# EUROPÄISCHE PATENTSCHRIFT

(11) **EP 0 870 328 B1**
(45) Veröffentlichungstag und Bekanntmachung des Hinweises auf die Patenterteilung: **18.08.2004**
(21) Anmeldenummer: 96945714.2
(22) Anmeldetag: 09.11.1996
(51) Int. Cl.: H01L 23/049, H01L 23/492, H01L 23/24

(54) **GLEICHRICHTERDIODE**
RECTIFIER DIODE
DIODE DE REDRESSEMENT

(30) Priorität: 30.12.1995 DE 19549202
(43) Veröffentlichungstag der Anmeldung: 14.10.1998
(73) Patentinhaber: ROBERT BOSCH GMBH, 70442 Stuttgart (DE)
(72) Erfinder: SPITZ, Richard, D-72766 Reutlingen (DE); SCHULER, Siegfried, D-72770 Reutlingen (DE)
(86) Internationale Anmeldenummer: PCT/DE1996/002139
(87) Internationale Veröffentlichungsnummer: WO 1997/024762

(56) Entgegenhaltungen:
- EP-A- 0 034 207
- FR-A- 2 412 166
- US-A- 5 005 069

## Beschreibung

### Stand der Technik

Die Erfindung betrifft eine Gleichrichterdiode nach dem Oberbegriff des Anspruchs 1. Es ist bekannt, Gleichrichterdioden mittlerer und höherer Leistungen als Einpreßdioden auszuführen. Die Einpreßdioden weisen dabei einen Einpreßsockel auf, der in einer entsprechenden Ausnehmung einer Gleichrichteranordnung eingepreßt wird. Der Einpreßsockel übernimmt dabei gleichzeitig eine dauerhafte thermische und elektrische verbindung der Gleichrichterdiode mit der Gleichrichteranordnung. Derartige Anordnungen sind beispielsweise aus der Kraftfahrzeugtechnik bekannt, wo sie als Gleichrichter in den Kraftfahrzeuggeneratoren eingesetzt werden. Der Einpreßsockel weist dabei einen Befestigungsbereich auf, auf dem ein Halbleiterchip beispielsweise durch Löten befestigt ist. Auf dem Halbleiterchip wiederum ist ebenfalls beispielsweise durch Löten ein sogenannter Kopfdraht befestigt, der elektrisch beispielsweise durch Löten oder Schweißen fest mit einer Phasenzuleitung des Kraftfahrzeuggenerators verbunden ist.

Beim Einpressen der Gleichrichterdiode in eine vorgesehene Öffnung einer Gleichrichteranordnung greifen am Rande der Gleichrichterdiode mechanische Kräfte auf diese an. Diese mechanischen Kräfte werden über den Einpreßsockel auf den Befestigungsbereich des Halbleiterchips übertragen. Beim Einpressen erfährt der auf dem Befestigungsbereich montierte Halbleiterchip eine Biegebeanspruchung. Auch die Lotschichten zwischen Halbleiterchip und Einpreßsockel sowie zwischen Halbleiterchip und Kopfdraht sind von der Biegebeanspruchung betroffen.

In der DE 41 12 286 A1 ist der Einpreßsockel aus massivem Metall ausgeführt, und zwar in Form eines zentrisch angeordneten Podests , auf dem der Halbleiterchip montiert ist. Dadurch ist be eits eine räumliche Trennung des Halbleiterchips vom Einpreßsockelrand, auf den die Einpreßkräfte einwirken, gegeben. Trotz der räumlichen Trennung erfahren der Chip und die ihn umgebenden Lotschichten eine Biegebeanspruchung, die zum sofortigen Ausfall oder später zum vorzeitigen Altern der Einpreßdiode führen kann.

Bei einer alternativen Konstruktion einer Gleichrichterdiode ohne Podest und dieses Podest umgebenden Wall hängt die Robustheit und Zuverlässigkeit des Bauteils davon ab, daß der Chip bei der Herstellung exakt zentriert befestigt ist.

### Vorteile der Erfindung

Aus der FR-A-2 412 166 ist eine Gleichrichterdiode bekannt, die als Einpressdiode in die dafür vorgesehenen Öffnungen einer Gleichrichteranordnung eingepresst werden kann. Die Gleichrichterdiode weist einen Sockel mit einem Podest auf, auf dem ein Halbleiterchip befestigt ist. Mit dem Halbleiterchip ist ein Kopfdraht verbunden. Der Sockel der Diode dient zur thermischen und elektrischen Verbindung der Diode mit dem Halbleiterchip. Der Sockel der Diode weist einen Graben und einen Wall auf, die in einem Abstand radial um das Podest verlaufen. Bezüglich des Abstandes und bezüglich des Verhältnisses von Breite des Walls und Tiefe des Grabens werden keine näheren Angaben gemacht. Auf der vom Graben abgewandten Seite des Walls ist ein Pressbereich vorgesehen, in welchem beim Einpressen der Diode Presskräfte wirken.

Die DE-A-4 341 269 zeigt eine Einpressdiode, die einen Sockel mit einem Podest aufweist, auf dem ein Halbleiterchip befestigt ist. Mit dem Halbleiterchip ist ein Kopfdraht verbunden. Der Sockel weist eine Vertiefung und eine Art Wall auf. Ober die Größenverhältnisse von Vertiefung und Wall werden keine näheren Angaben gemacht, da bei der aus der DE-A-4 341 269 bekannten Einpressdiode die Ausgestaltung und die Herstellung eines zusätzlichen Kragens wesentlich ist. Die Einpressdiode wird in einem, eine Rändelung aufweisenden Bereich in eine Gleichrichteranordnung eingepresst.

Die Gleichrichterdiode mit den im Hauptanspruch genannten kennzeichnenden Merkmalen hat demgegenüber den Vorteil, daß in einfacher Weise eine Robustheit bezüglich Deformation, beispielsweise beim Einpressen, erreicht wird. Dadurch, daß der Sockelboden im Bereich des Podests einen dieses Podest umgebenen Wall aufweist, der mit dem Sockelboden einstückig ist, kann durch einfache geometrische Variationen der Höhe des Walls und seine Abstands vom Podest die Steifigkeit des gesamten Sockels verbessert werden.

Insbesondere vorteilhaft ist die Anordnung eines Preßbereichs auf der vom Graben abgewandten Seite des Walls: Dadurch wird eine Robustheit der Gleichrichterdiode gegenüber Deformation beim Einpressen in eine Gleichrichteranordnung gewährleistet. Die Kombination von Preßbereich, Wall und Graben verringert die Biegebeanspruchung an der Chipauflagefläche im Vergleich zu einer Konstruktion ohne Wall.

Weiterhin ist vorteilhaft, daß der Preßbereich der Einpreßdiode durch einen Wall vom Sockel getrennt ist, dessen Höhe ungefähr halb so groß ist wie die Länge des Grabens zwischen Sockel und Wall. Bei minimaler Biegebeanspruchung während des Einpreßvorgangs erreicht man dabei im Rahmen gegebener Fertigungstechniken für den Sockel gleichzeitig eine geringere Fehlerquote bei der Herstellung, da die Chipzentrierung auf der Chipauflagefläche des Podests weniger kritisch ist.

Durch die in den abhängigen Ansprüchen aufgeführten Maßnahmen sind vorteilhafte Weiterbildungen und Verbesserungen der im Hauptanspruch gegebenen Gleichrichterdiode möglich.

Vorteilhaft ist die Kombination von Kopfzylinder und Kopfkegel, weil sie die Vorteile des Kopf Zylinders (hohe Wärmekapazität/große Masse für erforderliche Impulsfestigkeit der Diode) und des Kopfkegels (Steifigkeit gegen Zugbelastung des Kopfdrahts, kleine Bauhöhe der Gleichrichterdiode) in sich vereint.

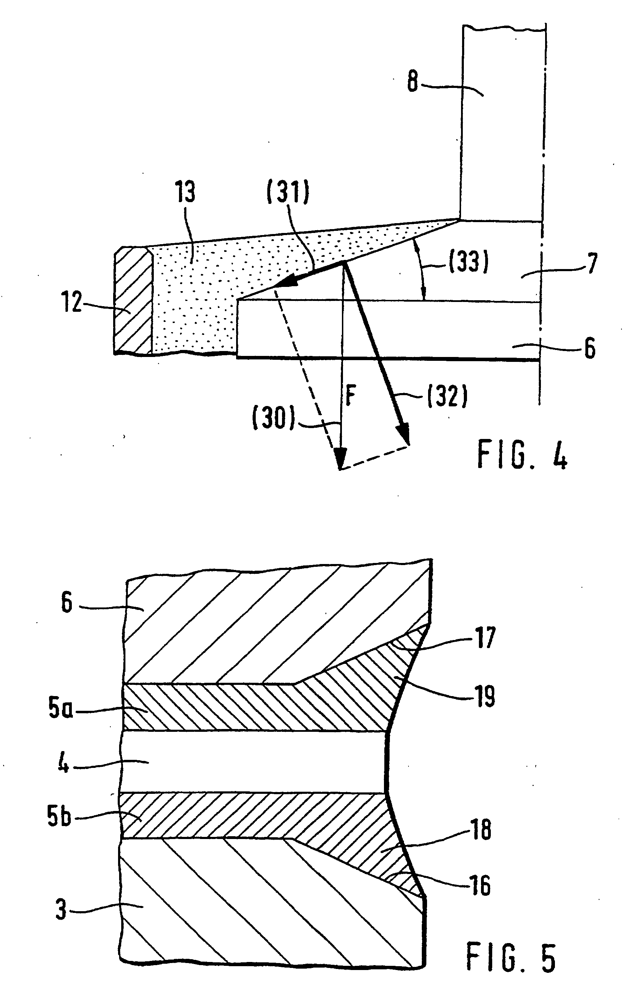

Vorteilhaft ist die optimierte Wahl des Winkels von ca. 20° im Sinne eines Formschlusses mit der Verpackung. Trotz schräger Kontaktfläche mit der Verpackung ist die für den Formschluß entscheidende normale Komponente der Zugkraft (Figur 4) nur wenige Prozent kleiner als die axiale Zugkraft selbst.

Vorteilhaft ist die kompakte Bauweise durch eine spezielle Ausgestaltung der Verpackung. Nur am Rande des Kopfes, dort, wo also große Kräfte über den Formschluß des Kopfes mit der Verpackung auftreten, beispielsweise wenn die Zugkraft am Kopfdraht auch nicht-axiale Komponenten aufweist, ist die Verpackung stark ausgelegt.

Das Anbringen einer Fase oder einer Stufe o.ä. am Kopfzylinder , am Sockel und/oder am Chip selber ist vorteilhaft, da sich am Rande des Chips eine dickere Lotschicht einstellen läßt im Vergleich zu einer-Konstruktion ohne Fase, Stufe o.ä. Dadurch wird die Lotermüdung am Chiprand reduziert.

Der Vorteil einer Schulter besteht darin, däß ein inniger Formschluß des Sockels mit der Verpackung besteht. Außerdem geht man bei der Herstellung der Verpackung beispielsweise von einer Gießharzmasse aus, die beim Trocknen.auf den Sockel aufschrumpft und dadurch den Kopfbereich der' Gleichrichterdiode samt Halbleiterchip fest an den Einpreßsockel drückt.

Eine schräge Kante an der Schulter vermeidet hohe mechanische Spannungen in der Verpackung, wenn die Gleichrichterdiode beispielsweise unter Zugbelastung steht. Hohe mechanische Belastungen oder auch thermische Spannungen bilden sich stets an scharfen Kanten aus. Durch die Verwendung einer schrägen Kante am Ende der Schulter wird eine solche scharfe Kante vermieden.

### Zeichnung

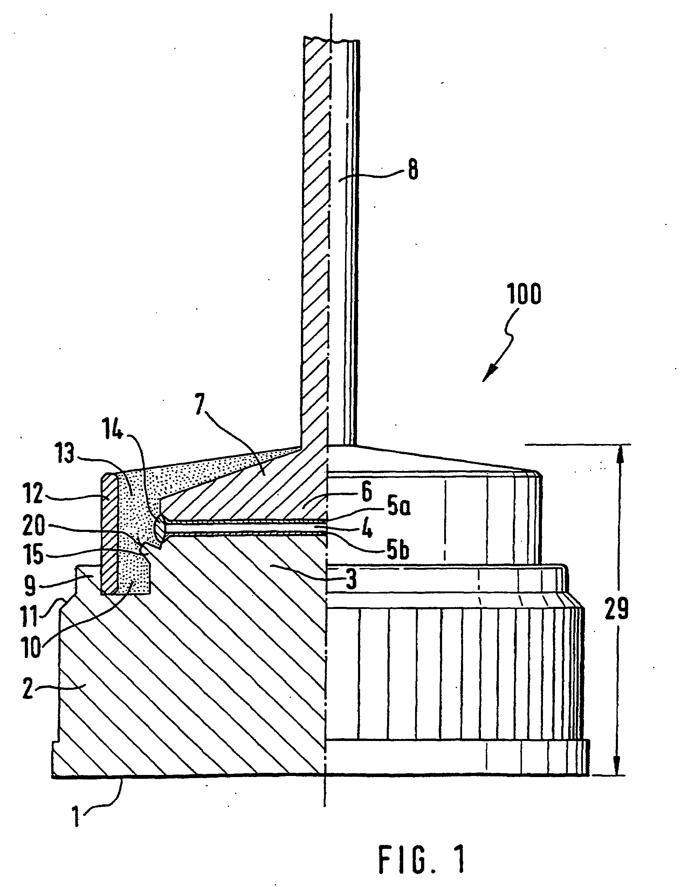

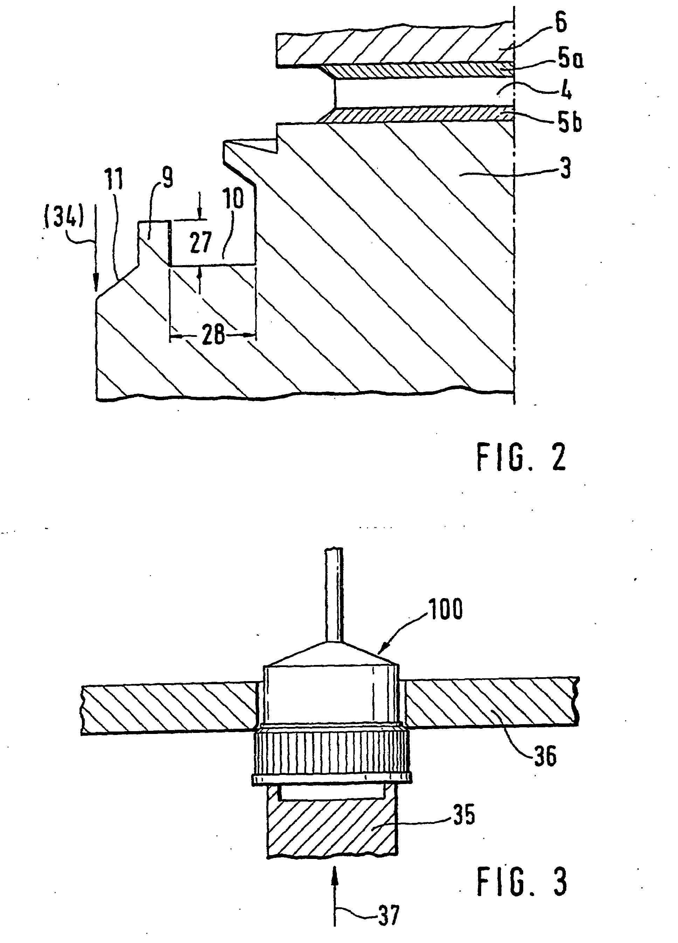

Ein Ausführungsbeispiel der Erfindung ist in der Zeichnung dargestellt und in der nachfolgenden Beschreibung näher erläutert. Es zeigen Figur 1 schematisch einen teilweise aufgeschnittenen Querschnitt einer Gleichrichterdiode, Figur 2 ein Detail aus Figur 1 in einer schematischen Vergrößerung, Figur 3 eine schematische Darstellung des Vorgehens beim Einpressen der Gleichrichterdiode, Figur 4 ein weiteres Detail aus Figur 1 in einer schematischen Vergrößerung, Figur 5 ein drittes Detail aus Figur 1 in einer schematischen Vergrößerung.

### Beschreibung des Ausführungsbeispiels

Figur 1 zeigt eine allgemein mit 100 bezeichnete, in einem teilweise aufgeschnittenen Querschnitt dargestellte Gleichrichterdiode. Die Gleichrichterdiode 100 besitzt einen Sockel 2 mit einem Sockelboden 1. Mit dem Sockel 2 ist einstückig ein Podest 3 verbunden, auf dem seinerseits, beispielsweise durch Löten (Lot 5b), ein Halbleiterchip angebracht ist. Der Halbleiterchip 4 seinerseits ist beispielsweise wiederum durch Löten (Lot 5a) über einen Kopfzylinder 6 und einen Kopfkegel 7 mit einem Kopfdraht 8 verbunden. Das vorzugsweise zentriert angeordnete Podest 3 ist von einem umlaufenden Wall 9 und einen durch den Wall 9 und das Podest 3 gebildeten Graben 10 umgeben. vom Podest 3 aus betrachtet befindet sich jenseits des Walls 9 noch ein Preßbereich 11, auf den beim Einpressen der Gleichrichterdiode 100 Kräfte senkrecht zur Ebene des Halbleiterchips 4 einwirken können. Der Kopfkegel 7, der Kopfzylinder 6, der Halbleiterchip 4 und das Podest 3 sind mit einer Verpackung 13 umgeben, die von einer Schutzhülse 12 begrenzt wird. Das Podest 3 und der Kopf Zylinder 6 weisen zum Halbleiterchip hin am Rande eine Fase 16 und/oder 17 auf (Figur 5). Diese Fasen können, beispielsweise mit Lot 18 und/oder 19, ausgefüllt sein. Ferner ist am Rande des Chips eine Passivierung 14 angebracht, die den Chip und das Lot am Chiprand versiegelt. Ferner weist das Podest 3 eine umlaufende Schulter 15 mit einer schrägen Kante 20 auf, die in die Verpackung 13 hineinragt.

Bei der in der Figur 1 gezeigten Gleichrichterdiode 100 ist besonders vorteilhaft, daß der Halbleiterchip 4 auf einem erhöhtem Podest 3 befestigt ist, der von einem Wall 9 umgeben ist. Der so gebildete Graben 10 hat dabei typischerweise eine Länge, die ca. doppelt so groß ist wie die Höhe des Walls 9. Der Vorteil der Erfindung besteht darin, daß die Konstruktion besonders robust ist gegenüber Deformation beim Einpressen der Gleichrichterdiode. Die Kombination von Podest und Wall/Graben gewährleistet eine homogenere. und niedrigere Biegebeanspruchung an der Chipauflagefläche im Vergleich zu einer Konstruktion ohne signifikant ausgebildeten Wall 9. Diese Robustheit wird durch Finite- Elemente-Rechnungen bestätigt. Ein weiterer Vorteil ist, daß die Chipzentrierung im Vergleich zu der Konstruktionsfigur 4 der Schrift DE 41 12 286 weniger kritisch ist. Bei der dort beschriebenen Konstruktion hängt die Robustheit und Zuverlässigkeit des Bauteils wesentlich davon ab, den Chip bei der Herstellung exakt zentriert zu befestigen. Vorzugsweise ist bei der erfinderischen Konstruktion der Wall niedriger als das Podest, u.a. um den Zugang zum Chip bei der Herstellung der Diode und bei der Passivierung nicht zu beeinträchtigen.

Nach Figur 1 weist die Gleichrichterdiode 100 an ihrem Sockel 2, beispielsweise am Umfang des Podests 3, eine Schulter 15 auf. Diese fakultative Schulter dient dazu, einen innigen Formschluß der Verpackung mit dem Sockel herzustellen. Zum einen ergibt sich mechanische Stabilität, der Sockel ist gewissermaßen mit der Verpackung 13 verhakt. Zum anderen drückt eine beispielsweise als Gießharzmasse ausgeführte Verpackung bei der Herstellung beim Austrocknen den Kopfteil der Diode samt Halbleiterchip auf den Sockel auf ("Aufschrumpfen"). So ergibt sich insgesamt eine stabile Konstruktion. Die Schulter 15 weist dabei eine schräge Kante 20 auf, wodurch das Auftreten hoher mechanischer Spannungen und die Gefahr der Rißbildung in der Verpackung bei äußeren mechanischen, aber auch thermischen Belastungen, vermieden wird, die bei einem spitz zulaufenden Ende der Schulter bestehen würde.

Figur 2 und 3 illustrieren den Einpreßvorgang bzw. die dabei auf die Gleichrichterdiode wirkende Kraft. Beim Einpressen der Gleichrichterdiode in eine Gleichrichteranordnung 36 verwendet man einen Einpreßstempel 35 (siehe Figur 3), der eine Einpreßkraft 37 auf den Sockel 2 der Gleichrichterdiode 100 überträgt. Vorzugsweise ist dabei der Einpreßstempel 35 so ausgebildet, daß er nur auf einen Randbereich des Sockelbodens drückt. Die Gleichrichteranordnung 36 übt eine Gegenkraft 34 auf den Preßbereich 11 des Sockels der Gleichrichterdiode 100 aus (siehe Figur 2). Der Halbleiterchip 4 und die ihn umgebenden Lotschichten 5a, 5b liegen zum einen deutlich höher als der Angriffspunkt der Kraft, die beim Einpressen auf den Sockel einwirkt, und zum anderen sind sie durch den umlaufenden Graben 10 vom Bereich starker Deformation entkoppelt. Dies hat zur Folge, daß die Wahrscheinlichkeit, den Chip durch das Einpressen zu beschädigen, deutlich reduziert wird. FEM-Berechnungen und auch Versuche haben dies bestätigt. Außerdem ist der Graben durch ein Breite- zu Tiefeverhältnis 2:1 so gestaltet, daß sich der Sockel kostengünstig herstellen läßt. Die robuste und einfache Konstruktion von Podest mit Wall und Graben erlaubt also die Anwendung hoher Einpreßkräfte bei minimaler Deformation des Halbleiterchips.

Die Befestigung des Kopfdrahts 8 (Figur 4) ist so gestaltet, daß drei wesentliche Anforderungen an diesen erfüllt werden:
1. Für eine hohe Impulsfestigkeit, wie sie für Dioden, insbesondere für die bei den Generatoren gebräuchlichen Zenerdioden, gefordert wird, muß der Kopf 6, 7 eine möglichst hohe Wärmekapazität haben. Bei gegebenen Material benötigt man also eine hinreichend große Masse. Begrenzend wirkt dabei die Forderung nach möglichst geringer Bauhöhe 29 der Gleichrichterdiode, wie sie für eine kompakte Bauweise erforderlich ist.
2. Der Kopf muß möglichst steif sein. Nach dem Einbau der Diode 100 in die Gleichrichteranordnung 36 wird der Kopfdraht B während des Betriebes durch Vibrationen auf Zug belastet. Ist der Kopf lediglich zylinderförmig ausgelegt, kann dies zu einer starken Durchbiegung führen, wenn Zugbelastungen senkrecht zur Ebene des Halbleiterchips auftreten. Dies führt zu einer stark inhomogenen Kräfteverteilung auf der anliegenden Lotschicht 5a, d.h. es kann lokal zu sehr hohen Spannungen in der Lotschicht kommen. Diese haben eine beschleunigte Alterung, eine Erhöhung des Wärmewiderstands und schließlich den vorzeitigen Ausfall der Diode zur Folge.
3. Für eine hohe Temperaturwechselfestigkeit der Diode 100 ist es erforderlich, zwischen Kopf 6, 7 und Sockel 2 einen Formschluß über die Verpackung 13 herzustellen. Hierzu muß der Kopf hinreichend mit Vergußmasse bedeckt sein. Allerdings trägt zur Verklammerung praktisch ausschließlich die Normalkomponente 32 der axialen Zugkraft 30 bei (Figur 4). Die tangentiale Komponente 31 der Zugkraft 30 kann als Klebekraft der vergußmasse an einer metallischen Oberfläche praktisch vernachlässigt werden. In diesem Sinne wäre es ideal, den Kopf zylinderförmig auszubilden. Dies widerspricht aber den Forderungen nach kompakter Bauhöhe bei gleichzeitig großer Steifigkeit.

Der Vorteil der Erfindung besteht hier nun darin, den Kopf aus einem Zylinder- und einem Kegelanteil auszubilden. Der Kopfkegel 7 erlaubt eine hinreichende Bedeckung mit Vergußmasse am Außendurchmesser, bei gleichzeitig kompakter Bauweise (kleine Bauhöhe). Bei einem Winkel 33 des Kopfkegels 7 von typischerweise 20° erhält man trotz der Kegelform weiterhin eine optimale Kraftnutzung für den Formschluß von Verpackung und Kopf von ca. 94 % der axialen Zugkraft. Durch die kegelförmige Ausgestaltung eines Teils des. Kopfes wird ferner die Steifigkeit beträchtlich erhöht und auftretende Zugkräfte somit gleichmäßig auf die gesamte Fläche verteilt. Der Kopfzylinder 6 hingegen gewährleistet eine möglichst große Masse, um bei gegebener spezifischer Wärmekapazität eine möglichst hohe Impulsfestigkeit der Zenerdiode zu gewährleisten.

Die spezielle Auslegung der Verpackung 13 im Bereich des Kopfes 6,7 stellt eine weitere Optimierung dar im Sinne einer kompakteren Bauweise. Die Verpackung 13 wird durch die Schulter 15 formschlüssig mit dem Sockel 2 verbunden. Weiterhin kann die Verpackung Kräfte auf den Kopf ausüben. Diese Kräfte sind im Randbereich des Kopfes höher als in der Mitte des Kopfes, in der der Kopfdraht befestigt ist. Die verpackung ist daher im Randbereich des Kopfes wesentlich dicker ausgelegt als im mittleren Bereich (Figur 1). So erhält man ausgehend von der Schutzhülse 12 beispielsweise einen leicht ansteigenden Verlauf der Verpackung 13 hin zum Kopfdraht 8.

Figur 5 zeigt ein Detail aus Figur 1 an der Kante des Halbleiterchips 4. Kopfzylinder 6 und Podest 3 weisen jeweils am Rande eine Fase 16 und 17 auf. Der freie Bereich zwischen Podest und Halbleiterchip bzw. Halbleiterchip und Kopfzylinder ist beispielsweise mit Lot 18 bzw. 19 aufgefüllt. Vorteilhaft daran ist, daß im Bereich der maximalen Durchmesser bei runden Chips oder geometrisch angepaßten Sockeln bzw. Köpfen auf dem gesamten Umfang sich eine dickere Lotschicht einstellen läßt, wodurch die Lotermüdung drastisch reduziert wird. Die Lotermüdung und insbesondere das Lotkriechen, die durch das unterschiedliche thermische Ausdehnungsverhalten von Silizium und Kopf bzw. Podest verursacht werden, hängen stark von den geometrischen Verhältnissen ab. Die Scherung der Lotschicht ist um so größer, je geringer die Schichtdicke des Lotes und je längerder gescherte Bereich ist. Über die Chipdiagonale bzw. an den Ecken würde das Lot verstärkt altern, und Lotkriechen könnte zum vorzeitigen Ausfall der Diode durch Kurzschluß führen. Durch den zusätzlich mit Lot ausgefüllten Bereich 18 und/oder 19 wird also eine extrem hohe Temperaturwechselfestigkeit der Diode erreicht. So vereint man den Vorteil einer dünnen Lotschicht in der Mitte des Chips (kleiner Wärmewiderstand) mit hoher Temperaturwechselfestigkeit. Alternativ zu einer Fase kann man auch eine Stufe vorsehen, kann der Sockel oder der Kopf im Bereich der Chipecken abgerundet sein. Alternativ kann diese Rundung, Fase, Stufe usw. auch am Chip angebracht sein. Die Passivierung 14 bedeckt dabei das Lot 18 und/oder 19.

## Patentansprüche

1. Gleichrichterdiode mit einem Sockel (2), die in eine vorgesehene Öffnung einer Gleichrichteranordnung (36) einpreßbar ist, wobei auf dem Sockel (2) einstückig mit dem Sockel ein Podest (3) angeordnet ist, auf dem seinerseits ein Halbleiterchip (4) befestigt ist, an dem seinerseits ein Kopfdraht (8) befestigt ist, wobei der Sockel zur thermischen und elektrischen Verbindung der Diode mit der Gleichrichteranordnung dient, und der Sockelboden (1) im Bereich des Podests (3) einen dieses Podest umgebenden Wall (91 auf weist, dass der vom Podest (3) durch einen Graben (10) getrennte Wall (9) mit dem Sockelboden (1) einstückig ist, dass auf der vom Graben (10) abgewandten Seite des Walls (9) zwischen dem Wall und einer zum Sockelboden im Wesentlichen senkrecht angeordneten Wandung des Sockels (2) ein Preßbereich (11) zur Aufnahme von senkrecht zur Ebene des Halbleiterchips (4) gerichteten Kräfte angeordnet ist, **dadurch gekennzeichnet, dass** der zwischen Wall (9) und Podest (3) ausgebildete Graben (10) eine radiale Ausdehnung hat, die im Wegentlichen doppelt so groß ist wie die Höhe des Walls (9) vom Graben (10) ab gerechnet..

2. Gleichrichterdiode nach Anspruch 1, **dadurch gekennzeichnet, dass** der Kopfdraht (8) über einen Kopfkegel (7) und einen Kopfzylinder (6) mit dem Halbleiterchip (4) verbunden ist.

3. Gleichrichterdiode nach Anspruch 2, **dadurch gekennzeichnet, dass** die Mantellinie des Kopfkegels (7) einen Winkel (33) von etwa 20° zur Ebene des Halbleiterchips (4) und die Gleichrichterdiode eine den Halbleiterchip (4) schützende Verpackung (13) aufweist.

4. Gleichrichterdiode nach Anspruch 2 oder 3, **dadurch gekennzeichnet, dass** sie eine den Halbleiterchip (4) schützende, im Bereich des äußeren Randes des Kopfkegels (7) im Vergleich zum Bereich in der Nähe des Kopfdrahtes (8) dickere Verpackung (13) aufweist.

5. Gleichrichterdiode nach einem der vorhergehenden Ansprüche, **dadurch gekennzeichnet, dass** das Podest (3) und/oder der Kopfzylinder (6) im Bereich des Halbleiterchips (4) am äußeren Rand eine Fase (16 und/oder 17) aufweist und dass im Bereich der Fase (16 und/oder 17) Lot (18 und/oder 19) angebracht ist.

6. Gleichrichterdiode nach einem der vorhergehenden Ansprüche, **dadurch gekennzeichnet, dass** das Podest (3) seitlich eine Schulter (15) aufweist, die in eine den Halbleiterchip (4) schützende Verpackung hineinragt.

7. Gleichrichterdiode nach Anspruch 6, **dadurch gekennzeichnet, dass** die Schulter (15) eine schräge Kante (20) aufweist.

## Claims

1. Rectifier diode having a base (2) which can be pressed into an opening provided in a rectifier array (36), a platform (3) being arranged on the base (2) so as to be integral with the base and to which, for its part, a semiconductor chip (4) is attached, to which, for its part, a header wire (8) is attached, the base being used to thermally and electrically connecting the diode to the rectifier array, and the bottom (1) of the base having, in the region of the platform (3), a wall (9) which surrounds this platform, in that the wall (9) which is separated from the platform (3) by a trench (10) is integral with the bottom (1) of the base, in that a pressing region (11) for absorbing forces which are directed perpendicularly to the plane of the semiconductor chip (4) is arranged on that side of the wall (9) which faces away from the trench (10), between the wall and a section of wall of the base (2) which is arranged essentially perpendicularly with respect to the bottom of the base, **characterized in that** the trench (10) which is formed between the wall (9) and platform (3) has a radial extent which is essentially twice as large as the height of the wall (9), calculated from the trench (10).

2. Rectifier diode according to Claim 1, **characterized in that** the header wire (8) is connected to the semiconductor chip (4) via a header cone (7) and a header cylinder (6).

3. Rectifier diode according to Claim 2, **characterized in that** the generating line of the header cone (7) has an angle (33) of approximately 20° with respect to the plane of the semiconductor chip (4), and the rectifier diode has packaging (13) which protects the semiconductor chip (4).

4. Rectifier diode according to Claim 2 or 3, **characterized in that** it has packaging (13) which protects the semiconductor chip (4) and is thicker in the region of the outer edge of the header cone (7) in comparison with the region in the vicinity of the header wire (8).

5. Rectifier diode according to one of the preceding claims, **characterized in that** the platform (3) and/or the header cylinder (6) have a chamfer (16 and/or 17) on the outer edge in the region of the semiconductor chip (4), and **in that** solder (18 and/or 19) is provided in the region of the chamfer (16 and/or 17).

6. Rectifier diode according to one of the preceding claims, **characterized in that** the platform (3) has at the side a shoulder (15) which projects into packaging which protects the semiconductor chip (4).

7. Rectifier diode according to Claim 6, **characterized in that** the shoulder (15) has an oblique edge (20).

## Revendications

1. Diode de redressement avec un socle (2), qui peut être enfoncée dans une ouverture prévue dans un ensemble redresseur (36), sur le socle (2), d'un seul tenant avec le socle, un palier (3) étant disposé sur lequel est d'une part fixée une puce à semi-conducteur (4), sur lequel est d'autre part fixé un fil de tête (8), le socle servant à la liaison thermique et électrique de la diode avec l'ensemble redresseur, alors que le fond de socle (1), dans la zone du palier (3) présente un rempart (9) entourant ce palier, le rempart (9) séparé du palier (3) par un fossé (10) étant d'un seule pièce avec le fond de socle (1), et avec, sur le côté du rempart (9) opposé au fossé, entre le fossé et une paroi du palier (2) disposée pour l'essentiel verticalement par rapport au fond de socle, une zone de pression (11) disposée pour absorber des forces dirigées perpendiculairement au plan de la puce à semi-conducteur (4),
**caractérisée en ce que**
le fossé (10) prévu entre le rempart (9) et le palier (3) présente une extension radiale qui correspond pour l'essentiel à deux fois la hauteur du rempart (9) calculée depuis le fossé (10).

2. Diode de redressement selon la revendication 1,
**caractérisée en ce que**
le fil de tête (8) est relié à la puce à semi-conducteur (4) par un cône de tête (7) et un cylindre de tête (6).

3. Diode de redressement selon la revendication 2,
**caractérisée en ce que**
l'enveloppante du cône de tête (7) présente un angle (33) de 20° environ par rapport au plan de la puce à semi-conducteur (4), et la diode de redressement présente un emballage (13) protégeant la puce à semi-conducteur (4).

4. Diode de redressement selon la revendication 2 ou 3,
**caractérisée en ce qu'**
elle présente un emballage (13) protégeant la puce à semi-conducteur (4) plus épais dans la zone du bord extérieur du cône de tête (7) que dans la zone à proximité du fil de tête (8).

5. Diode de redressement selon l'une quelconque des revendications précédentes,
**caractérisée en ce que**
le palier (3) et/ou le cylindre de tête (6) présentent un chanfrein (16 et/ou 17) dans la zone de la puce à semi-conducteur, au niveau du bord extérieur, et avec une brasure (18 et/ou 19) disposée dans la zone du chanfrein (16 et/ou 17) du plomb.

6. Diode de redressement selon l'une quelconque des revendications précédentes,
**caractérisée en ce que**
le palier (3) présente latéralement un épaulement (15) saillant dans un emballage protégeant la puce à semi-conducteur (4).

7. Diode de redressement selon la revendication 6,
**caractérisée en ce que**
l'épaulement (15) présente une arête inclinée (20).
